# EUROPEAN PATENT SPECIFICATION

(11) **EP 1 518 247 B1**
(45) Date of publication and mention of the grant of the patent: **08.02.2006**
(21) Application number: 03726431.4
(22) Date of filing: 22.04.2003
(51) Int. Cl.: G11C 16/16, G11C 16/04, G11C 11/56

(54) **METHOD OF ERASING A FLASH MEMORY USING A PRE-ERASING STEP**
VERFAHREN ZUM LÖSCHEN EINES FLASH-SPEICHERS UNTER VERWENDUNG EINES PRÄ-LÖSCH VERFAHRENSSCHRITTS
PROCEDE D'EFFACEMENT D'UNE MEMOIRE FLASH PASSANT PAR UNE ETAPE DE PRE-EFFACEMENT

(30) Priority: 24.05.2002 US 155767
(43) Date of publication of application: 30.03.2005
(73) Proprietor: ADVANCED MICRO DEVICES, INC., Sunnyvale, California 94088-3453 (US)
(72) Inventor: LE, Binh, Quang, San Jose, CA 95131 (US); HAMILTON, Darlene, San Jose, CA 95120 (US); TANPAIROJ, Kulachet, Palo Alto, CA 94305 (US); LIU, Zhizheng, Sunnyvale, CA 94087 (US); HE, Yi, Fremont, CA 94555 (US); ZHENG, Wei, Sunnyvale, CA 94087 (US); CHEN, Pau-Ling, Saratoga, CA 95070 (US); VANBUSKIRK, Michael, Saratoga, CA 95070 (US)
(74) Representative: Wright, Hugh Ronald
(86) International application number: PCT/US2003/012636
(87) International publication number: WO 2003/100790

(56) References cited:
- US-A- 5 898 621
- US-A- 5 931 563
- US-A- 5 959 893
- US-A- 6 147 904
- US-A1- 2002 031 012

## Description

### TECHNICAL FIELD

This invention relates generally to flash memory systems and to a method of erasing flash memory cells used in flash memory systems. In particular this invention relates to dual bit flash memory systems and to a method of erasing a sector of an array of dual bit flash memory cells used in a flash memory system. Even more particularly, this invention relates to dual bit flash memory systems and a method of erasing a sector that provides erase uniformity of all bits in the dual bit flash memory system and that provides an increase in speed of the erase routine.

### BACKGROUND ART

Flash memory is a type of electronic memory media that can be rewritten and that will hold its content without consuming power. Flash memory devices generally have life spans from 100K to 300K write cycles. Unlike dynamic random access memory (DRAM) and static random access memory (SRAM) memory chips, in which a single byte can be erased, flash memory is typically erased and written in fixed multi-bit blocks or sectors. Evolving out of electrically erasable read only memory (EEPROM) chip technology, which can be erased in place; flash memory is less expensive and is denser. This new category of EEPROMs has emerged as an important non-volatile memory which combines the advantages of EPROM density with EEPROM electrical erasability.

Conventional flash memories are constructed with a cell structure in which a single bit of information is stored in each cell. In such single bit memory architectures, each cell typically includes a metal oxide semiconductor (MOS) transistor structure having a source, a drain, and a channel in a substrate or P-well, as well as a stacked gate structure overlying the channel. The stacked gate may further include a thin gate dielectric layer (sometimes referred to as a tunnel oxide) formed on the surface of the P-well. The stacked gate also includes a polysilicon floating gate overlying the tunnel oxide and an interpoly dielectric layer overlying the floating gate. The interpoly dielectric layer is often a multi layer insulator such as an oxide-nitride-oxide (ONO) layer having two oxide layers sandwiching a nitride layer. Lastly, a polysilicon control gate overlies the interpoly dielectric layer.

The control gate is connected to a word line associated with a row of such cells to form sectors in a typical NOR configuration. In addition, the drain regions of the cells are connected together by a conductive bit line. The channel of the cell conducts current between the source and drain controlled by an electric field developed in the channel by the stacked gate structure. In the NOR configuration, each drain terminal of the transistors within a single column is connected to the same bit line. In addition, each flash cell has its stacked gate terminal connected to a different wordline and all the flash cells in the array have its source terminals connected to a common source terminal. In operation, individual flash cells are addressed via the respective bitline and wordline using peripheral decoder and control circuitry for programming (writing), reading or erasing.

A single bit stacked gate flash memory cell is programmed by applying a voltage to the control gate and connecting the source to ground and the drain to a predetermined potential above the source. A resulting high electric field across the tunnel oxide leads to a phenomenon called "Fowler-Nordheim" tunneling. During Fowler-Nordheim tunneling, electrons in the core cell channel region tunnel through the gate oxide into the floating gate and become trapped in the floating gate since the floating gate is surrounded by the interpoly dielectric and the tunnel oxide. As a result of the trapped electrons, the threshold voltage of the cell increases. This change in the threshold voltage (and thereby the channel conductance) of the cell created by the trapped electrons causes the cell to be programmed.

In order to erase a typical single bit stacked gate flash memory cell, a voltage is applied to the source, the control gate is held at a negative potential and the drain is allowed to float. Under these conditions, an electric field is developed across the tunnel oxide between the floating gate and the source. The electrons that are trapped in the floating gate flow toward and cluster at the portion of the floating gate overlying the source region, are extracted from the floating gate and in to the source region by way of Fowler-Nordheim tunneling through the tunnel oxide. The cell is erased as the electrons are removed from the floating gate.

In conventional single bit flash memory devices, erase verification is performed to determine whether each cell in a block or set of cells has been completely erased. Current single bit erase verification methodologies provide for verification of cell erasure and an application of supplemental erases to individual cells that fail initial erase verification. The erase status of the cell is again verified and the process continues until the cell is successfully erased or the cell is determined to be unusable.

Recently, dual bit flash memory cells have been introduced that allow the storage of two bits of information in a single memory cell. The conventional programming and erase verification methods employed with single bit stacked gate architectures are not adequate for such dual bit devices. The dual bit flash memory structures do not utilize a floating gate, such as the ONO flash memory device that employs a polysilicon layer over the ONO layer for providing wordline connections. Techniques that have been developed with conventional single bit flash memory devices do not work well for the new dual bit flash memory cells.

The dual bit flash memory cell uses what is known as a virtual ground architecture in which the source of one bit serves as the drain of an adjacent bit. During read operations the junction nearest the cell being read is the ground terminal and the other side of the cell is the drain terminal. This is called reverse read. The drain is switched during programming and erase back to the nearest junction being the Vdrain voltage instead of ground, which is used for read and verify operations. A problem with dual bit operation is that since an entire sector of memory cells of the array is block erased a typical flash memory array device cannot support the erase current generated by the relatively large number of cells being simultaneously erased during the double or dual bit erase routing.

A method of erasing a sector of a flash memory as indicated in the preamble of claim 1 is known from US2002/031012.

Therefore, what is needed is a method of erasing the flash memory cells rapidly and in a way that the charge pump of the memory array device can support the erase current.

### DISCLOSURE OF THE INVENTION

According to the present invention, the objects and advantages are achieved by a method of erasing a sector of a flash memory device as indicated in claim 1.

In accordance with a first aspect of the invention, all the cells in a sector are pre-programmed and all the cells in the sector are pre-erased by application of at least one set of pre-erase voltages.

In accordance with a second aspect of the invention, all the cells in the sector are erase verified after the application of the at least one set pre-erase voltages and if all the cells verify as erased all of the cells are subjected to a soft programming routine.

In accordance with a third aspect of the invention, if all the cells do not verify as erased after the pre-erase period, all of the cells are subjected to a standard erase routing.

In accordance with a fourth aspect of the invention, the at least one set of pre-erase voltages is a set of preset pre-erase voltages preset by a metal option mask layer applied during the manufacture of the flash memory device or by CAMs (Content Addressable Memories) programmed during testing before shipping.

In accordance with a fifth aspect of the invention, after the application of the initial set of preset pre-erase voltages it is determined whether the number of erase pulses has exceeded or not exceeded the number of erase pulses preset for the initial set of preset pre-erase voltages. If not, additional pulses at the initial set of pre-erase voltages are applied to he sector. If the number of applied pulses equals the number of erase pulses preset for the initial set of preset pre-erase voltage, it is determined if another set of preset pre-erase voltages is to be applied. If not, the routine goes to the standard erase routine, if another set of preset pre-erase voltages is to be applied, a next set of preset pre-erase voltages is applied to the sector.

In accordance with a sixth aspect of the invention, after the application of the preset sets of pre-erase voltages is complete and if the sector does not verify as erased, the sector is subjected to a standard erase routine.

The described invention thus provides a method of erasing an entire sector of a flash memory device uniformly without decreasing the speed of the erasure and without exceeding the available current from a standard charge pump.

The present invention is better understood upon consideration of the detailed description below and in conjunction with the accompanying drawings. As will become readily apparent to those skilled in the art from the following description, there is shown and described an embodiment of the invention simply by way of illustration of the best mode to carry out the invention. As will be realized, the invention is capable of other embodiments and its several details are capable of modifications in various obvious aspects, all without departing from the scope of the invention. Accordingly, the drawings and detailed description will be regarded as illustrative in nature and not as restrictive.

### BRIEF DESCRIPTION OF DRAWINGS

The novel features believed characteristic of the invention are set forth in the appended claims. The invention itself, however, as well as a preferred mode of use, and further objects and advantages thereof, will best be understood by reference to the following detailed description of an illustrative embodiment when read in conjunction with the accompanying drawings, wherein:
**Figure 1** is a side cross-sectional view of an exemplary dual bit memory cell with which various aspects of the present invention may be implemented;
**Figure 2A** is a schematic showing the interconnections of a portion of an array;
Figure 2B illustrates the problem associated with a method of erasing portions of a sector of flash memory cells;
**Figure 3** illustrates a block schematic diagram of a system adapted to carry out various aspects of the invention; and
**Figure 4** is a flow diagram illustrating the method of utijizing stepped pre-erase voltages in accordance with the present invention.

### MODE(S) FOR CARRYING OUT THE INVENTION

Reference is now made in detail to a specific embodiment or specific embodiments of the present invention that illustrate the best mode or modes presently contemplated by the inventors for practicing the invention.

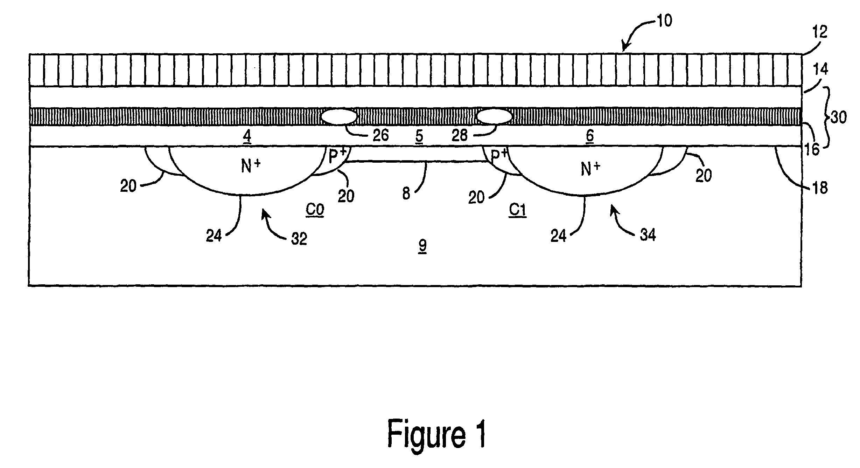

Referring now to the drawings, **Figure** 1 illustrates an exemplary dual bit memory cell **10** in which one or more of the various aspects of the invention may be carried out. The memory cell **10** comprises a silicon nitride layer **16** sandwiched between a top silicon dioxide layer 14 and a bottom silicon dioxide layer **18** forming what is known as an ONO layer **30.** A polysilicon layer **12** resides over the ONO layer **30** and provides a wordline connection to the memory cell 10. A first bitline 32 runs underneath the ONO layer 30 under a first region **4** and a second bitline **34** runs underneath the ONO layer **30** under a second region 6. The bitlines **32** and **34** are formed of a conductive material **24.** Boron core implants **20** are provided on both ends of each bitline **32** and **34** where the bitlines meet the bottom silicon dioxide layer **18** or along the entire transistor. The boron core implants are more heavily doped than the P-type substrate **9** and assist in control of the VT of the memory cell **10.** The cell **10** resides on a P-type substrate **9** with the conductive portion **24** of the bitlines **32** and **34** formed from an N⁺ arsenic implant, such that a channel **8** is formed across the P-type substrate **9.** The memory cell **10** is a single transistor having interchangeable source and drain components formed from the N⁺ arsenic implant portions **24** residing on the P-type substrate region **9** with a gate formed as part of a polysilicon wordline **12.**

The silicon nitride layer **16** forms a charge trapping layer. Programming a cell is accomplished by applying appropriate voltages to the bitline acting as the drain terminal, to the gate and grounding the source bitline acting as the source terminal. The voltages generate electrical fields along the channel causing electrons to accelerate and jump from the substrate layer **9** into the layer **16** of nitride, which is known as hot electron injection. Since the electrons gain the most energy at the drain, these electrons become trapped and remain stored in the layer 16 of nitride near the drain. The cell **10** is generally uniform and the drain and source are interchangeable. Since the layer **16** of silicon nitride is non-conducting, a first charge **26** can be injected into the nitride **16** near a first end of the central region **5** and a second charge **28** can be injected into the layer **16** of silicon nitride near a second end of the central region **5.** Therefore, if the charge does not move there can be two usable bits per cell instead of one bit per cell.

As previously stated, the first charge **26** can be stored in the layer **16** of silicon nitride at a first end of the central region **5** and the second charge **28** can be stored at the other end of the central region **5** such that two bits can reside per memory cell **10**. The dual bit memory cell **10** is symmetrical allowing the drain and the source to be interchangeable. Thus, the first bitline **32** may serve as the drain terminal and the second bitline **34** as the source terminal when programming the left bit C0. Likewise, the second bitline **34** may serve as the drain terminal and the first bitline **32** as the source terminal for programming the right bit C1.

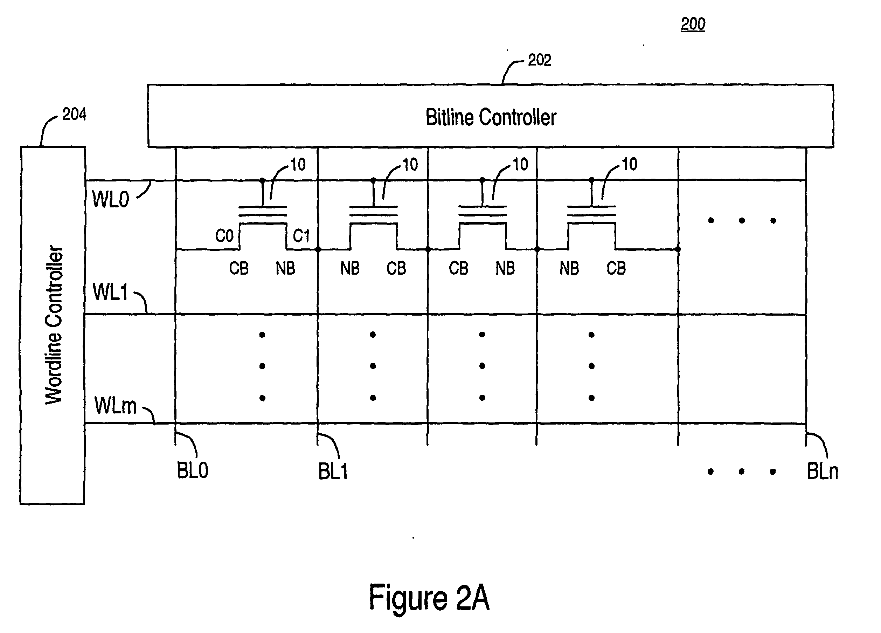

Referring now to **Figure 2A,** a portion of a sector of cells **200** is shown. The sector is an array of double bit flash memory cells, such as the cells **10** shown and described in **Figure 1.** The portion of the sector of cells **200** includes a bitline controller **202** and a wordline controller **204** that decode I/Os during various operations that are performed on the sector **200** (e.g., operation such as programming, reading, verifying, erasing). The bitline controller **202** and wordline controller **204** receive address bus information from a system controller (not shown) or the like. Dual bit flash memory cells such as cell s **10** are formed in m rows and n columns. A common wordline is attached to the gate of each cell in a row, such as wordlines WL0, WL1, WL2, and WLm. A common bitline is attached to each bit of a cell in a column, such as bitlines BL0, BL1, and BLn.

**Figure 2A** and **Table 1** illustrate one particular set of voltage parameters for performing reading, programming and single sided erases of the dual bit memory cell **10** having the first bit C0 and the second bit C1.

**TABLE 1**

| **Operation** | **Cell** | **Gate** | **Bitline 0** | **Bitline 1** | **Comment** |
|---|---|---|---|---|---|
| Read | C0 | 4.7v | 0v | 1.2v | Complimentary bit |
| Read | C1 | 4.7v | 1.2v | 0 v | Normal bit |
| Program. | C0 | Vpp | 5-6v | 0v | Hot electron |
| Program | C1 | Vpp | 0v | 5-6v | Hot electron |
| Two-side erase | C1, C0 | -3 to -6v | 5 to 6v | 5 to 6v | Hot hole injection |
| One side-erase | C0 | -3 to -6v | 5 to 6 v | Float | Hot hole injection |
| One side-erase | C1 | -3 to -6v | Float | 5 to 6v | Hot hole injection |

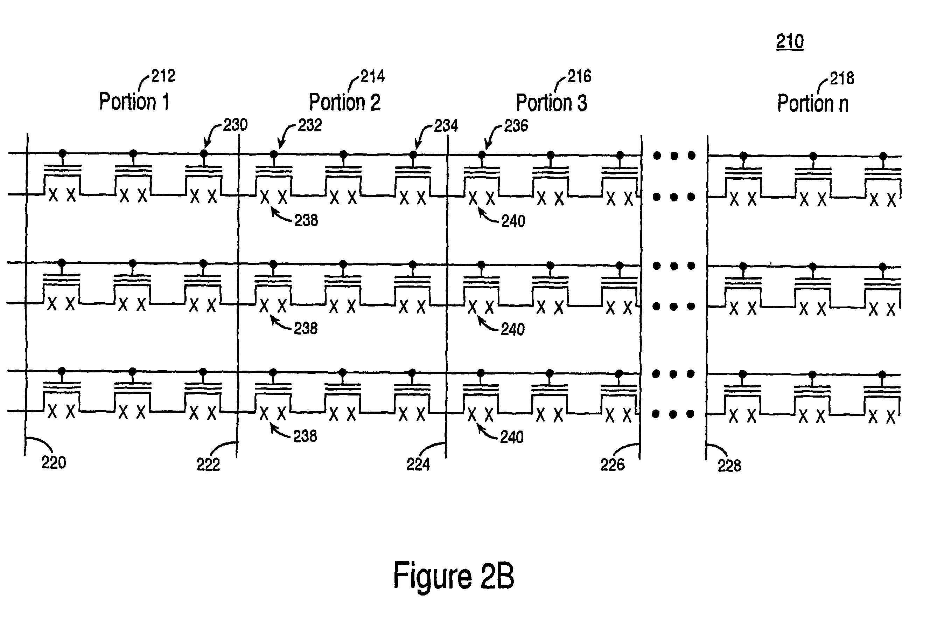

**Figure 2B** shows sector **210** of a memory device that has been divided into logical portions **212-218** for reasons that will be discussed below. The boundaries of the portions **212-218** are indicated by lines **220, 222, 224, 226** & **228,** which also represent bitlines that are shared by adjacent cells. The memory device has been divided into the portions **212-218** because if the entire sector is erased, the total erase current flowing in the device will exceed the current available to the device from the typical device charge pump at the standard erase voltage. **Figure 2B** is an illustration of one method of avoiding the high current in which the sector of the memory device is divided in to the logical portions **212-218** so that sector can be erased one portion at a time. Although erasing one portion of the sector at a time decreases the current in the memory device during the erase routing, another problem exists. This problem is that some of the bits are one-sided erased while other bits are two-sided erased. The column of cells indicated at **230** shared the bitline represented by line **222** with the column of cells indicated at **232** and the column of cells indicated **at 234** shares the bitline represented by line **224** with the column of cells indicated **236.** Therefore, each time the portion **212** is erased the column of the bits **238** would also be erased because the gate erase voltage would be applied to the gates of cells (the wordlines are common to all the cells in the sector) in column of the bits **238** and the drain erase voltage would be applied to all the bitlines in portion **212** including the bitline represented by the line **222.** Although the intended bits to be erased are in the cells in portion **212** including the cells in column **230,** the bits indicated at **238** are also erased. Similarly, the column of the bits **240** would be erased when the portion **214** is erased. Therefore the bits in the column of cells **232** and **240** are one-sided erased while the bits in the remaining columns are two-sided erased. As is known in the art, the non-uniformity of characteristics between bits that are one-sided erased and two-sided erased cause problems in the operation of the memory device.

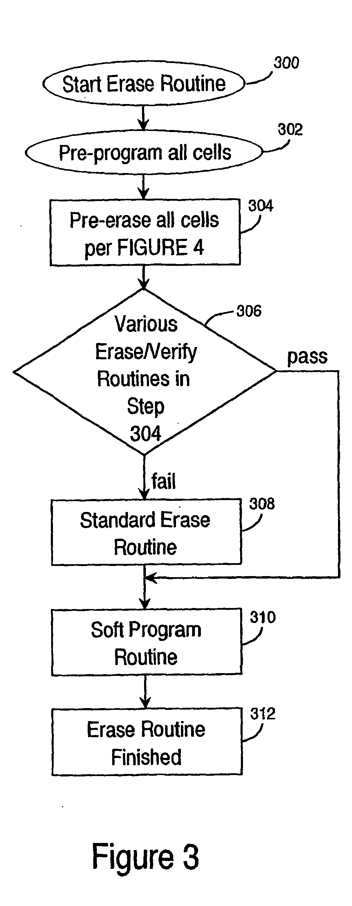

**Figure 3** is a flow diagram of a method of erasing the entire sector of the memory array without dividing the sector of the memory array into logical portions as shown in **Figure 2B** and without exceeding the maximum current available from the memory sector charge pump. The method utilizes a pre-erase routine in which one or more sets of stepped pre-erase voltages is/are applied to the entire sector of the memory array in such a way that the total current during each of the one or more sets of pre-erase voltages is less than the maximum amount of current available from the memory sector charge pump. As should be appreciated, the sets of stepped pre-erase voltages serve to decrease the VT of the cells in steps, which serves to decrease the band-to-band current thus decreasing the current required from the charge pump. As is known, a charge pump can supply more current at lower output voltages..

**TABLE 2** lists some of the stepped erase voltages that can be applied to the cells during a pre-erase routine. The number of different sets of per-erase voltages and the order of application of the sets of pre-erase voltages to be applied to a specific memory device are preset by a mask applied during the manufacture of the memory device or by the programmed CAMs. The number of different sets and the order application of the pre-erase voltages, as well as the number of erase pulses per set of pre-erase voltages is determined during a preproduction characterization routine, either by computer modeling, empirical testing or testing of preproduction samples. For example, the application of only one set of pre-erase pulses may be sufficient for the specific device. Another example is that set 1 (from **TABLE 2** below) of pre-erase pulses would be applied to the device followed either by set 2 or by set 3 or by all three sets. Another example would be that only set **3** would be applied. In addition, the number of pre-erase pulses can vary as preset in the mask. For example, the number of pre-erase pulses could be 1 or more than 1 in each of the sets in **TABLE 2.**

**TABLE2**

| | | | |
|---|---|---|---|
| Set 1 pre-erase pulses | No. of pulses | Vgate = -8V | Vdrain = 5V |
| Set 2 pre-erase pulses | No. of pulses | Vgate = -7.5V | Vdrain = 5.3V |
| Set 3 pre-erase pulses | No. of pulses | Vgate = -7V | Vdrain = 5.6V |
| Standard erase | No. of pulses | Vgate = -6V | Vdrain = 6V |

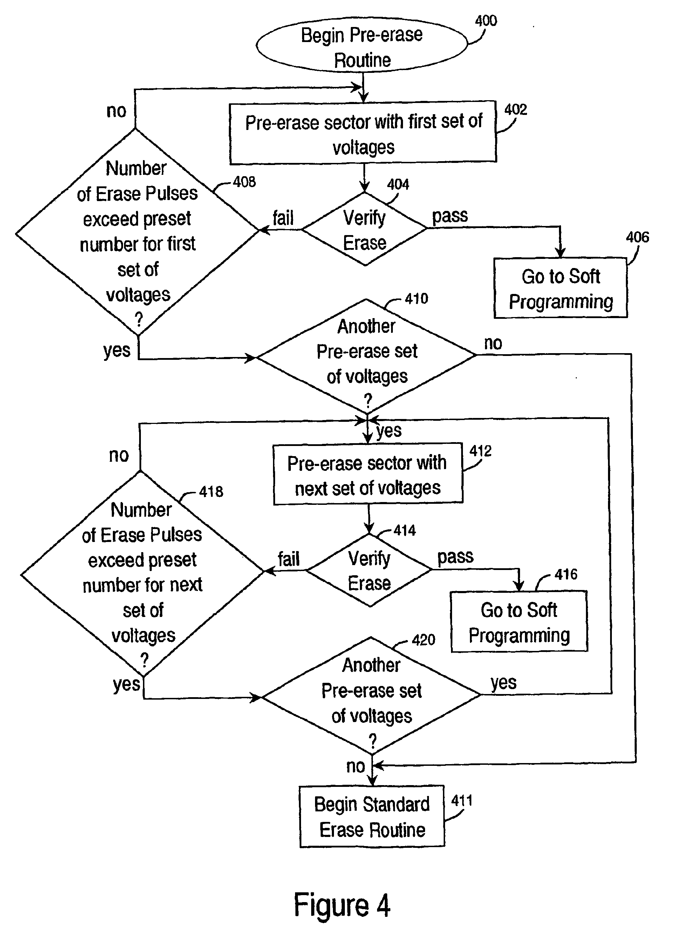

Referring again to **Figure 3,** the erase routine is started at **300.** All of the cells in the sector to be erased are programmed at **302.** At step **304,** the pre-erase routine in accordance with the present invention begins and the specific steps will be described in conjunction with Figure **4** below. As indicated at **306,** after the application of each set of pre-erase voltages during the pre-erase routines during step **304** an erase/verify step is performed and if the sector passes (all cells erased) the standard erase routine at **308** is bypassed and the routine goes directly to the soft program as indicated at **310.** If any of the erase/verify steps at **306** fail (and there are no further pre-erase sets of pre-erase voltages scheduled) the routine then goes to the standard erase routine at **308** because the band-to-band current has been reduced. After the soft program routine at **310** is completed, the erase routine is considered finished as indicated at **312.**

**Figure 4** is a flow diagram of the application of the pre-erase routine of the present invention. The pre-erase routine begins at **400.** At **402** a set of pre-erase voltages is applied to the sector of cells. As described above, which set pre-erase voltages from **TABLE 3** is preset by a mask during manufacture of the flash memory device or by programming the CAMs. The number and order of application of the set of pre-erase voltages, the values of the voltages and the number of pulses of each set of pre-erase pulses are determined during a precharacterization procedure and can be done empirically, by testing pre-production samples or by computer modeling using parameters learned from other flash memory devices and depends upon the amount of reduction of the band -to-band current. The applied pre-erase voltages could be the voltages described as set I erase pulses, set 2 erase pulses, set 3 erase pulses. After the application of the initial set of pre-erase voltages at **402,** a verify erase routine is conducted at **404.** If the sector verifies as erased, that is, if the sector passes, the routine bypasses any further pre-erase voltage applications and the standard erase routine and goes directly to the soft programming routine at **406.** If the sector does not pass the verify erase at step **404,** it is determined at **408** if the number of erase pulses applied to the sector has exceeded a preset number of erase pulses preset during the manufacture of the memory device. If the number of erase pulses has not exceeded the number of preset erase pulses, the routine returns to step **402** where additional pre-erase pulses at the initial voltages are applied to the sector. If the number of erase pulses has exceeded the number of preset erase pulses, it is determined at **410** whether another set of pre-erase voltages is to be applied to the sector. As described above, the next set of pre-erase pulses that have been preset are listed in **TABLE 2** and if the initial set of pre-erase pulses are the ones listed as set 1 erase pulse in **TABLE 2** the next set of pre-erase pulses could be the set listed as the set 2, set 3 or all other pulses in **TABLE 2.** If the initial set of pre-erase pulses was preset as the set listed as set 2, then the next set could be chosen from the ones listed as set 3 erase pulse or all other erase pulses in **TABLE 2**. If it is determined at **410** that no further pre-erase set of voltages is to be applied, the routine goes to the standard erase routine at **411.** If it is determined at **410** that further erase pulses are to be applied, the next set of voltages is applied at **412.** A verify erase routine is conducted at **414.** If the sector passes the verify erase routine **414,** any further erase routines are bypassed and the sector is subjected to soft programming as indicated at **416.** If the sector fails the erase verify routine at **414** it is determined at **418** if the preset number of erase pulses of the next set of voltages has been exceeded. If the preset number of erase pulses has not been exceeded at **418** the routine returns to step **412.** If the preset number of erase pulses has been exceeded at **418** the routine goes to step **420** where it is determined if another set of pre-erase voltages is to be applied to he sector. If there is to be another set of pre-erase voltages applied to the sector the routine returns to step **412.** If it is determined at **420** there is no further set of pre-erase voltages to be applied the routine goes to step **411** and the standard erase routine is applied to the sector.

In summary, the described invention provides a method of erasing an entire sector of a flash memory device uniformly without decreasing the speed of the erasure and without exceeding the available current from a standard charge pump.

The foregoing description of the embodiment of the invention has been presented for purposes of illustration and description. It is not intended to be exhaustive or to limit the invention to the precise form disclosed. Obvious modifications or variations are possible in light of the above teachings. The embodiment was chosen and described to provide the best illustration of the principles of the invention and its practical application to thereby enable one of ordinary skill in the art to utilize the invention in various embodiments and with various modifications as are suited to the particular use contemplated. All such modifications and variations are within the scope of the invention as determined by the appended claims when interpreted in accordance with the breadth to which they are fairly, legally, and equitably entitled.

## Claims

1. A method of erasing a sector of a flash memory device, the method comprising:
(a) programming all cells in the sector (302);
(b) pre-erasing all cells in the sector (304);
(c) erase verifying all cells in the sector (306);
(d) if all of the cells verify as erased performing a soft program routine (310); and
(e) if all of the cells do not verify as erased begin a standard erase routine (312),
wherein step (b) is accomplished by:
(f) pre-erasing the sector with an initial set of preset set of voltages (402);
(g) verifying erase of the sector (404) and if the sector verifies as erased soft programming the sector (406), otherwise go to step (h);
**characterized by** (h) determining if the number of erase pulses applied during step (f) exceeds a preset number of erase pulses for the initial preset set of voltages (408) and if the number of erase pulses do not exceed the preset number of erase pulses for the initial preset set of voltages, further applying additional erase pulses (402), otherwise determining if another set of pre-erase voltages is to be applied (410).

2. The method of claim 1 wherein:
the initial preset set of voltages is preset by a mask layer applied during the manufacture of the flash memory device.

3. The method of Claim 2 wherein step (b) is further accomplished by:
(i) pre-erasing the sector with a next preset set of voltages (412) if it is determined that another set of voltages is to be applied to the sector;
(j) verifying erase of the sector (414) if the next set of voltages have been applied to the sector and if the sector verifies as erased, soft programming the sector (416) otherwise go to step (k);
(k) determining if the number of erase pulses applied during step (i) exceeds a preset number of erase pulses for the next preset set of voltages (418) and if the number of erase pulses do not exceed the preset number of erase pulses for the next preset set of voltages further applying additional erase pulses otherwise determining if another set of pre-erase set of voltages is to be applied.

4. The method of Claim 3 further comprising:
(l) repeating steps (i) through (k) until it is determined that another set of pre-erase set of voltages is not to be applied wherein:
(m) a standard erase routine is applied.

5. The method of Claim 1, wherein said pre-erasing comprises using a pulse with a gate voltage between -6V and -8V.

6. The method of Claim 1, wherein said pre-erasing comprises using a pulse with a drain voltage between 5V and 6V.

7. The method of Claim 1, wherein said pre-erasing comprises using pre-erase voltages determined during a preproduction characterization routine.

8. The method of Claim 1, wherein said pre-erasing comprises using a set of pre-erase voltages selected from a number of sets of pre-erase voltages.

9. The method of Claim 1, wherein said flash memory device is a dual bit flash memory device.

10. The method of Claim 1, wherein said flash memory device comprises a virtual ground architecture (210).

## Patentansprüche

1. Verfahren zum Löschen eines Sektors einer Flash-Speichereinrichtung, wobei das Verfahren umfasst:
a) Programmieren aller Zellen in dem Sektor (302);
b) vorläufiges Löschen aller Zellen in dem Sektor (304);
c) Verifizieren des Löschens aller Zellen in dem Sektor (306);
d) wenn alle Zellen als gelöscht verifiziert sind, Ausführen des schwach Programmierungsablaufs (310); und
e) wenn alle Zellen nicht als gelöscht verifiziert werden, Beginnen eines standardmäßigen Löschablaufs (312), wobei der Schritt b) erreicht wird durch:
f) vorläufiges Löschen des Sektors mit einem Anfangssatz aus vorgegebenen Sätzen aus Spannungen (402);
g) Verifizieren des Löschens des Sektors (404), und wenn der Sektor als gelöscht verifiziert wird, schwaches Programmieren des Sektors (406), ansonsten Weitergehen zum Schritt h);
**gekennzeichnet durch**
h) Bestimmen, wenn die Anzahl der Löschpulse, die während des Schritts f) angelegt wurden, eine vorgegebene Anzahl an Löschpulsen für den vorgegebenen Anfangssatz an Spannungen (408) übersteigt, und wenn die Anzahl der Löschpulse die vorgegebene Anzahl der Löschpulse für den vorgegebenen Anfangssatz an Spannungen nicht übersteigt, weiterhin zusätzliche Löschpulse (402) anlegen, ansonsten Bestimmen, ob ein weiterer Satz an vorläufigen Löschspannungen anzulegen ist (410).

2. Verfahren nach Anspruch 1, wobei:
der vorgegebene Anfangssatz an Spannungen mittels einer Maskenschicht vorgegeben wird, die während der Herstellung der Flash-Speichereinrichtung aufgebracht wird.

3. Verfahren nach Anspruch 2, wobei der Schritt b) ferner erreicht wird durch:
(i) vorläufiges Löschen des Sektors mit einem nächsten vorgegebenen Satz an Spannungen (412), wenn bestimmt wird, dass ein weiterer Satz an Spannungen an den Sektor anzulegen ist;
(j) Verifizieren des Löschens des Sektors (414), wenn der nächste Satz an Spannungen an den Sektor angelegt worden ist und wenn der Sektor als gelöscht verifiziert wird, schwaches Programmieren des Sektors (416), ansonsten Weitergehen zum Schritt (k);
(k) Bestimmen, ob die Anzahl der Löschpulse, die während des Schritts (i) angelegt wurden, eine vorgegebene Anzahl an Löschpulsen für den nächsten vorgegebenen Satz an Spannungen (418) übersteigt, und wenn die Anzahl der Löschpulse die vorgegebene Anzahl an Löschpulsen für den nächsten vorgegebenen Satz an Spannungen übersteigt, weiterhin Anlegen zusätzlicher Löschpulse, ansonsten Bestimmen, ob ein weiterer Satz eines Satzes an Spannungen für vorläufiges Löschen anzulegen ist.

4. Verfahren nach Anspruch 3, das ferner umfasst:
(l) Wiederholen der Schritte (i) bis (k), bis bestimmt wird, dass ein weiterer Satz an Spannungen für vorläufiges Löschen nicht anzulegen ist, wobei:
wobei:
(m) ein standardmäßiger Löschablauf angewendet wird.

5. Verfahren nach Anspruch 1, wobei das vorläufige Löschen umfasst: Verwenden eines Pulses mit einer Gatespannung zwischen - 6 Volt und - 8 Volt.

6. Verfahren nach Anspruch 1, wobei das vorläufige Löschen umfasst: Verwenden eines Pulses mit einer Drainspannung zwischen 5 Volt und 6 Volt.

7. Verfahren nach Anspruch 1, wobei das vorläufige Löschen umfasst: Anwenden von Spannungen für das vorläufige Löschen, die durch eine der Herstellung vorausgehende Bestimmungsroutine bestimmt werden.

8. Verfahren nach Anspruch 1, wobei das vorläufige Löschen umfasst: Anwenden eines Satzes an Spannungen für das vorläufige Löschen, die aus einer Anzahl von Sätzen an Spannungen für vorläufiges Löschen ausgewählt werden.

9. Verfahren nach Anspruch 1, wobei die Flash-Speichereinrichtung eine Doppelbit-Flash-Speichereinrichtung ist.

10. Verfahren nach Anspruch 1, wobei die Flash-Speichereinrichtung eine Architektur mit virtueller Masse (210) aufweist.

## Revendications

1. Procédé d'effacement d'un secteur d'un dispositif à mémoire flash, le procédé comprenant les étapes consistant à :
(a) programmer toutes les cellules dans le secteur (302) ;
(b) pré-effacer toutes les cellules dans le secteur (304) ;
(c) vérifier l'effacement de toutes les cellules dans le secteur (306) ;
(d) si la totalité des cellules est vérifiée comme étant effacée, exécuter une routine de programme logiciel (310) ; et
(e) si la totalité des cellules n'est pas vérifiée comme étant effacée, commencer une routine d'effacement standard (312),
dans lequel l'étape (b) est réalisée en :
(f) pré-effaçant le secteur avec un ensemble initial d'un ensemble préétabli de tensions (402) ;
(g) vérifier l'effacement du secteur (404) et, si le secteur est vérifié comme effacé, programmer par logiciel le secteur (406), sinon aller à l'étape (h) ;
**caractérisé par** le fait de
(h) déterminer si le nombre d'impulsions d'effacement appliquées pendant l'étape (f) dépasse un nombre préétabli d'impulsions d'effacement pour l'ensemble initial préétabli de tensions (408) et si le nombre d'impulsions d'effacement ne dépasse pas le nombre préétabli d'impulsions d'effacement pour l'ensemble préétabli initial de tensions, appliquer de plus des impulsions d'effacement supplémentaires (402), sinon déterminer si un autre ensemble de tensions de pré-effacement doit être appliqué (410).

2. Procédé selon la revendication 1 dans lequel :
l'ensemble initial préétabli de tensions est préétabli par une couche de masquage appliquée pendant la fabrication du dispositif à mémoire flash.

3. Procédé selon la revendication 2 dans lequel l'étape (b) est réalisée, de plus, en
(i) pré-effaçant le secteur avec un nouvel ensemble préétabli de tensions (412) s'il est déterminé qu'un autre ensemble de tensions doit être appliqué au secteur;
(j) vérifiant l'effacement du secteur (414) si le nouvel ensemble de tensions a été appliqué au secteur et si le secteur est vérifié comme étant effacé, programmer par logiciel le secteur (416) sinon aller à l'étape (k) ;
(k) déterminant si le nombre d'impulsions d'effacement appliquées pendant l'étape (i) dépasse un nombre préétabli d'impulsions d'effacement pour le nouvel ensemble préétabli de tensions (418) et si le nombre d'impulsions d'effacement ne dépasse pas le nombre préétabli d'impulsions d'effacement pour le nouvel ensemble préétabli de tensions, appliquer, de plus, des impulsions d'effacement supplémentaires, sinon, déterminer si un autre ensemble d'ensemble de tensions de pré-effacement doit être appliqué.

4. Procédé selon la revendication 3 consistant, de plus, à :
(l) répéter les étapes (i) à (k) jusqu'à ce qu'il soit déterminé qu'un autre ensemble d'ensemble de tensions de pré-effacement n'a pas à être appliqué dans lequel :
(m) une routine d'effacement standard est appliquée.

5. Procédé selon la revendication 1 dans lequel ledit pré-effacement consiste à utiliser une impulsion présentant une tension de grille comprise entre -6V et - 8V.

6. Procédé selon la revendication 1 dans lequel ledit pré-effacement consiste à utiliser une impulsion présentant une tension de drain comprise entre 5V et 6V.

7. Procédé selon la revendication 1 dans lequel ledit pré-effacement consiste à utiliser des tensions de pré-effacement déterminées pendant une routine de caractérisation de pré-production.

8. Procédé selon la revendication 1 dans lequel ledit pré-effacement consiste à utiliser un ensemble de tensions de pré-effacement sélectionnées à partir d'un certain nombre d'ensembles de tensions de pré-effacement.

9. Procédé selon la revendication 1 dans lequel ledit dispositif à mémoire flash est un dispositif à mémoire flash à double binaire.

10. Procédé selon la revendication 1 dans lequel ledit dispositif à mémoire flash comprend une architecture de terre virtuelle (210).
